# EUROPEAN PATENT SPECIFICATION

(11) **EP 3 453 897 B1**
(45) Date of publication and mention of the grant of the patent: **10.09.2025**
(21) Application number: 18182912.8
(22) Date of filing: 11.07.2018
(51) Int. Cl.: F16B 7/00, F16B 12/00

(54) **DISPLAY MOUNTING APPARATUS**
ANZEIGEMONTAGEVORRICHTUNG
APPAREIL DE MONTAGE D'ÉCRAN

(30) Priority: 31.07.2017 KR 20170097020
(43) Date of publication of application: 13.03.2019
(73) Proprietor: LG Display Co., Ltd., SEOUL, 07336 (KR)
(72) Inventor: Kim, Hanseok, 10845 Gyeonggi-do (KR); Lee, Seungchul, 10845 Gyeonggi-do (KR)
(74) Representative: Ter Meer Steinmeister & Partner

(56) References cited:
- US-A1- 2016 255 731
- US-B1- 6 499 907

## Description

### BACKGROUND

### 1. Technical Field

The present disclosure relates to a mounting apparatus and an apparatus and a method for assembling a display module using the same, and more particularly, to a mounting apparatus in which an engagement portion is not exposed to the outside when a panel is connected, and an apparatus and method for assembling a display module using the same.

### 2. Description of the Related Art

Generally, a display module is a device for displaying visual information and is used in various fields such as mobile phones, television, personal digital assistants (PDAs), digital cameras, and computer monitors.

The display module is manufactured in a large scale according to the development of information technology, and a curved surface display module in which a curvature is formed on a surface of the display module is developed and used.

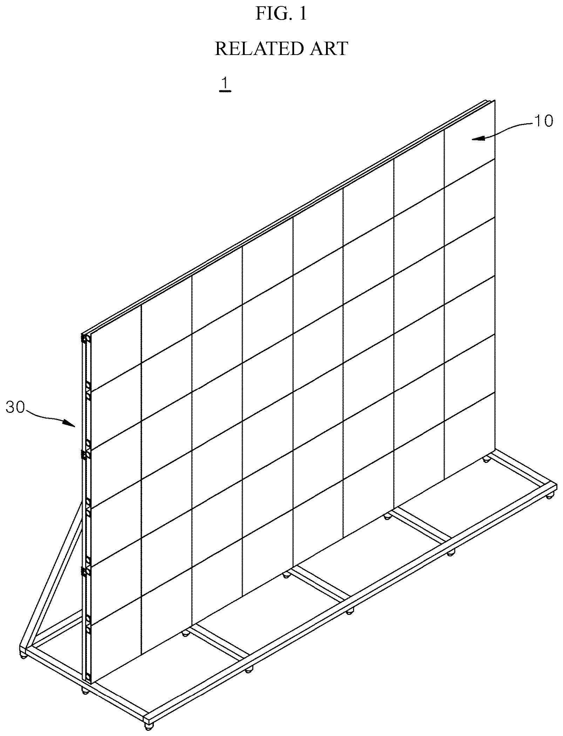

Recently, as shown in FIG. 1, a multi-display device 1 in which a plurality of display modules 10 are connected to extend a display area and a limit of visual information has been used.

The multi-display device 1 is provided in a form of a narrow bezel type or a zero bezel type in which there is almost no interval between the plurality of display modules 10 connected to each other.

Further, the multi-display device 1 may include a profile structure body 30 configured to mount the plurality of display modules 10 thereon. The profile structure body 30 may be provided in a grid shaped frame structure to support the plurality of display modules 10.

Meanwhile, since there is almost no interval between the plurality of display modules 10 in the multi-display device 1, there is a structural limitation in that the plurality of display modules 10 cannot be coupled to the profile structure body 30 in front of each of the plurality of display modules 10.

Accordingly, in case of the conventional multi-display device 1, the plurality of display modules 10 are installed to the profile structure body 30 in the rear of the plurality of display modules 10 using engagement members such as bolts, clamps, and the like.

In a state in which the plurality of display modules 10 are installed at the profile structure body 30, the multi-display device 1 may be installed on one's feet by embedding the profile structure body 30 in a wall surface or the like, or coupling a separate support member and a housing to the profile structure body 30.

Further, if one of the plurality of display modules 10 is needed to be repaired or replaced, it is difficult to separate the one of the plurality of display modules 10 from the conventional multi-display device 1 because an engagement portion is not exposed on a front side of the conventional multi-display device 1.

Further, there may conventionally be a mechanism tolerance of the profile structure body 30 at which the plurality of display modules 10 are installed, and accordingly, it is difficult to perform an alignment operation for accurately arranging the plurality of display modules 10 at the profile structure body 30. Furthermore, since a coupling operation for the plurality of display modules 10 is performed in the rear of the conventional multi-display device 1, a coupled state of a front surface of each of the plurality of display modules 10 cannot be determined and thus conditions of the plurality of display modules 10 such as the coupled state or a stepped level cannot be recognized. Accordingly, it results inconvenience because the conditions of the front side of each of the plurality of display modules 10 should frequently be checked during assembly.

Furthermore, owing to a conventional installation structure of each of the plurality of display modules 10, detaching or attaching of each of the plurality of display modules 10 is not easy, a large amount of work time is required, work difficulty is very high, and thus overall productivity is deteriorated such that there is an increasing need to improve an installation structure of the plurality of display modules 10.

US 2016/255731 A1 discloses a mounting structure for a display screen. The mounting structure includes a cabinet for fixing the display screen. The cabinet includes an outer frame that is connected to an external fixed structure and a panel that is detachably connected to the outer frame. The outer frame is fixedly connected to the panel through a lock mechanism in a locked state and is separated from the panel when the lock mechanism is opened. The cabinet is divided into the separate panel and the outer frame, and the outer frame that is lighter in weight is installed at first and then the panel is detachably connected to the outer frame by the lock mechanism.

### SUMMARY

Therefore, it is an objective of the present disclosure to provide an improved mounting apparatus for improving an installation structure of a display module and selectively detaching or attaching singular display module required for replacement or repair, and an apparatus and method for assembling a display module using the same.

Objects of the present disclosure are not limited to the above-described objects and other objects and advantages can be appreciated by those skilled in the art from the following descriptions. Further, it will be easily appreciated that the objects and advantages of the present disclosure can be practiced by means recited in the appended claims and a combination thereof.

There is provided a mounting apparatus comprising an interlocked rotational engagement body including an engagement member, and a magnetic member fixed to the engagement member.

The mounting apparatus may be adapted to be fixed to an engagement plate by a rotational movement of the engagement member induced by a magnetic force acting on the magnetic member.

The interlocked rotational engagement body may further comprise a disc including a through-hole and a stepped seating recess and the engagement member may comprise a body
passing through the through-hole and a head portion, wherein the head portion and the magnetic member are seated, in particular hooked, in the stepped seating recess.

The mounting apparatus may further comprise a bearing unit, wherein the bearing unit includes a first wheel, and a second wheel; wherein the first wheel is attached to the interlocked rotational engagement body. In particular, the first wheel may be attached to the disc.

The bearing unit may further comprise a rolling member.

The bearing unit may further comprise a retainer, wherein the rolling member is rotatably coupled by the retainer between the first wheel and the second wheel.

It is further provided a display module comprising a display panel, and at least one aforementioned mounting apparatus, wherein the mounting apparatus is fixed to a backside of the display panel. In particular, the second wheel of the mounting apparatus may be fixed to the backside of the display panel.

It is provided a profile structure body comprising at least one engagement plate adapted to receive an aforementioned display module.

The engagement plate may comprise an accommodation recess for accommodating the mounting apparatus.

The profile structure body may further comprise a nut member, wherein the nut member is adapted to receive the body of the engagement member, and a nut housing, wherein the nut member is accommodated in the nut housing.

It is further provided a rotation module comprising a rotatable magnetic force generation portion adapted for rotating the interlocked rotational engagement body of an aforementioned mounting apparatus by magnetic forces acting on the magnetic member of mounting apparatus.

The magnetic force generation portion may comprise an electromagnet module.

The rotation module may comprise a motor.

The rotation module may comprise an auxiliary bearing unit.

It is further proposed a display module assembly apparatus comprising at least one aforementioned rotation module, wherein the display module assembly apparatus is adapted for fastening an aforementioned display module to an aforementioned profile structure body according to any one of claims.

The display module assembly apparatus may further comprise an alignment unit including an image capturing unit for capturing an image of a corner of the display module.

The alignment unit may further comprise an image display unit.

The alignment unit may further comprises a position correction unit.

It is further proposed a multi-display device comprising at least one aforementioned display module and an aforementioned profile structure.

There is provided a mounting apparatus including at least one interlocked rotational engagement body interlocked and rotated with an assembling apparatus located on a front surface of a display module, and coupled to a profile structure body provided on a rear surface of the display module; and a bearing unit having a first wheel attached to the at least one interlocked rotational engagement body, and a second wheel attached to one side of the rear surface of the display module, and to which the at least one interlocked rotational engagement body is rotatably coupled.

The interlocked rotational engagement body may include a disc having an outer circumferential portion attached to the first wheel of the bearing unit; an engagement member having a body coupled to pass through a central portion of the disk and coupled to the profile structure body, and a head portion formed at a rear end portion of the body and hooked to the disk; and a magnetic member provided on at least one side of the head portion and configured to rotate the engagement member by a magnetic force.

A seating groove may be formed at the disc to allow the head portion and the magnetic member to be seated on the seating recess.

The profile structure body may include a plurality of profiles connected to each other; an engagement plate coupled to the plurality of profiles and having a through-hole corresponding to the engagement member at one side of the engagement plate; and a nut coupling portion provided behind the through-hole of the engagement plate, and to which the engagement member is coupled.

The nut coupling portion may include a nut member coupled to the engagement member; a nut housing provided to block surroundings of the through-hole on a rear surface of the engagement plate, and configured to accommodate the nut member in a state in which the nut member is straight upright.

The bearing unit may include a thrust ball bearing having a plurality balls between the first wheel and the second wheel.

The bearing unit may include a thrust needle roller bearing having a plurality of truncated conical rollers between the first wheel and the second wheel.

There is provided an apparatus for assembling a display module, which includes a frame located on a front surface of a display module; and at least one rotation module installed at one side of the frame by corresponding to the above-described mounting apparatus, configured to generate attraction to the mounting apparatus, and being in close contact with the display module.

The at least one rotation module may include a housing installed at the frame; and a motor installed inside the housing; and a rotational interlocking portion rotated by being connected to a rotational shaft of the motor and configured to rotate an interlocked rotational engagement body of the mounting apparatus.

The rotational interlocking portion may include a magnetic force generation portion configured to generate a magnetic force to the magnetic member to rotate an engagement member.

The magnetic force generation portion may include an electromagnet module, and a switch is provided at one side of the frame to control a supply of electricity to the electromagnet module.

The mounting apparatus may be installed at a predetermined position on the basis of a corner of the display module, and the apparatus for assembling a display module may further include an alignment unit configured to sense a corner of adjacent display module and align the at least one rotation module to a position corresponding to the mounting apparatus.

The alignment unit may recognize an interval between adjacent display modules at the corner of the display module and aligns a position of the display module.

The alignment unit may include at least one image capturing unit installed at one side of the rotation module and configured to capture an image of the corner of the display module; and an image display unit installed at one side of the frame and configured to display an image captured by the at least one image capturing unit.

There is provided a method for assembling a display module, which includes attaching the above-described apparatus for assembling a display module to a front surface portion of the display module to which a mounting apparatus is attached; moving the display module to an attachment position of a front surface portion of a profile structure body using the apparatus for assembling a display module; and coupling the display module to the attachment position.

The attaching may include aligning an attachment position of the display module using an alignment unit of the display module.

The aligning may include aligning a position of the display module while maintaining a constant interval between the display module and adjacent display modules at a corner of the display module through an image display unit of the aligning unit.

The coupling may include rotating an interlocked rotational engagement body of the mounting apparatus provided at the display module in responding to a rotation of a rotation module; and coupling the display module to a profile structure body.

### BRIEF DESCRIPTION OF DRAWINGS

FIG. 1 is a perspective view of a multi-display device.
FIG. 2 is a perspective view illustrating a state in which the multi-display device is assembled using an assembling apparatus according to one embodiment of the present disclosure.
FIG. 3 is a side view illustrating the state in which the multi-display device is assembled using the assembling apparatus according to one embodiment of the present disclosure.
FIG. 4 is a perspective view illustrating a part of a mounting apparatus according to one embodiment of the present disclosure.
FIG. 5 is an exploded perspective view of the mounting apparatus according to one embodiment of the present disclosure.
FIG. 6 is a perspective view of a display module assembling apparatus according to one embodiment of the present disclosure.
FIG. 7 is a perspective view illustrating a state in which a display module is assembled using the display module assembling apparatus according to one embodiment of the present disclosure.
FIG. 8 is a cross-sectional view illustrating the state in which the display module is assembled using the display module assembling apparatus according to one embodiment of the present disclosure.

### DETAILED DESCRIPTION

Certain terms are defined herein for easy understanding. Unless specifically defined herein, scientific and technical terms used herein shall have the meanings commonly understood by those skilled in the art. As used herein, the singular forms are intended to include plural forms and vice versa, unless the context clearly indicates otherwise.

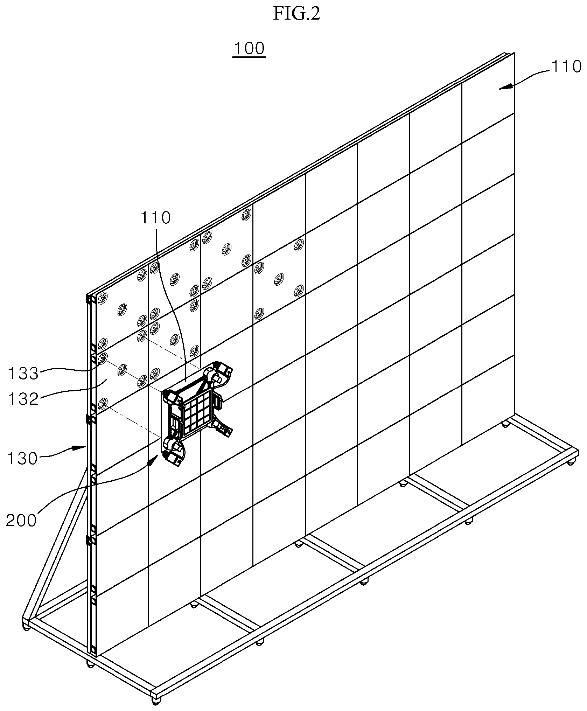

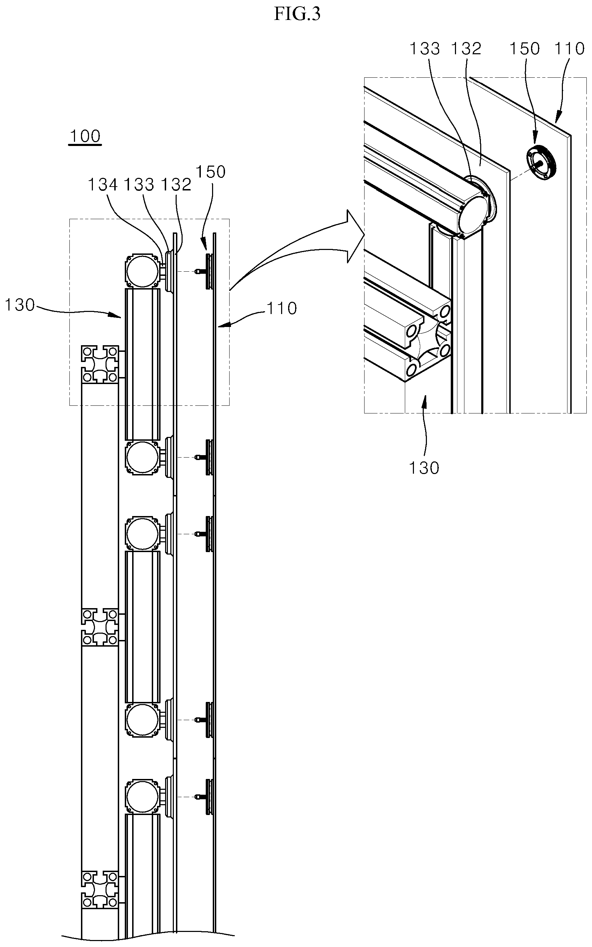

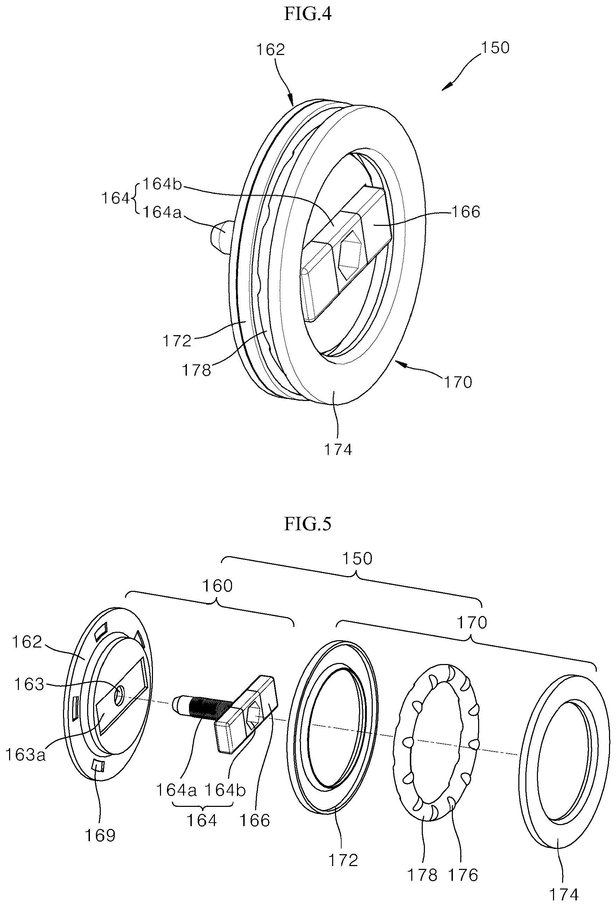

FIG. 2 is a perspective view illustrating a state in which the multi-display device is assembled using an assembling apparatus according to one embodiment of the present disclosure, and FIG. 3 is a side view illustrating the state in which the multi-display device is assembled using the assembling apparatus according to one embodiment of the present disclosure. Further, FIG. 4 is a perspective view illustrating a part of a mounting apparatus according to one embodiment of the present disclosure, and FIG. 5 is an exploded perspective view of the mounting apparatus according to one embodiment of the present disclosure.

Hereinafter, a mounting apparatus 150 and a display module assembly apparatus 200 including the mounting apparatus 150 according to one embodiment of the present disclosure will be described with reference to FIGS. 2 to 5.

The mounting apparatus 150 according to one embodiment of the present disclosure is an apparatus configured to couple a display module 110 to a profile structure body 130. The profile structure body 130 may be installed at a wall surface, a place at which the multi-display device 1 is installed, a separate support member, or the like.

Further, the display module 110 may directly be coupled to the profile structure body 130 via the mounting apparatus 150, and also an engagement plate 132 to which a coupling member such as a bracket or a nut, which is coupled to the mounting apparatus 150, is coupled may be provided at the profile structure body 130.

An accommodation recess 133 may be formed at the engagement plate 132 to accommodate the mounting apparatus 150, and a nut member 134 for a coupling may be provided at a rear side of the accommodation recess 133.

The mounting apparatus 150 may include at least one interlocked rotational engagement body 160. The interlocked rotational engagement body 160 may be coupled to the profile structure body 130 provided at a rear side of the display module 110.

The interlocked rotational engagement body 160 may be rotated by being interlocked with the display module assembly apparatus 200 located at a front side of the display module 110. At this point, the interlocked rotational engagement body 160 may be provided to be rotated without a physical contact with the display module assembly apparatus 200.

Further, the interlocked rotational engagement body 160 is rotatably coupled to the rear side of the display module 110, and, to this end, a bearing unit 170 to which the interlocked rotational engagement body 160 is rotatably coupled is provided between the interlocked rotational engagement body 160 and the rear surface of the display module 110.

The bearing unit 170 may include a first wheel 172 having one side attached to the interlocked rotational engagement body 160 and a second wheel 174 having one side attached to one side of the rear side of the display module 110, and rolling member 176 may rotatably be coupled by a retainer 178 between the first wheel 172 and the second wheel 174.

Specifically, the interlocked rotational engagement body 160 may include a disc 162 having an outer circumferential portion attached to the first wheel 172 of the bearing unit 170, and an engagement member 164 may be provided at the disc 162 to be coupled to the profile structure body 130.

To this end, a through-hole 163 may be formed at a central portion of the disc 162.

A plurality of protrusion parts 169 can be formed on an outer circumferential portion of the disc 162 and they are isolated from each other along the outer circumferential portion of the disc 162.

When the disc 162 is coupled to its counterpart by means of a screw, the protrusion parts 169 function to reduce a gap between the components but to increase friction force between them, thereby preventing the coupling between them from being decoupled.

The protrusion parts 169 can be formed by use of a press processing.

According to an exemplary embodiment of the present invention, the protrusion parts 169 are formed in the trapezoid shape, but they are not limited to this shape.

Further, the engagement member 164 may include a body 164a coupled to pass through the through-hole 163 of the disc 162, and a head portion 164b formed at a rear end portion of the body 164a and hooked to the disc 162.

A spiral portion may be formed on an outer circumferential surface of the body 164a and be screw-engaged with the profile structure body 130 by passing through the disc 162. The engagement member 164 may be kept in a state of being coupled to the profile structure body 130 as the head portion 164b is hooked to and is in close contact with the disc 162 while the body 164a is coupled to the profile structure body 130.

Further, a magnetic member 166 may be installed on at least one side of the head portion 164b to rotate the engagement member 164 by a magnetic force.

Preferably, the head portion 164b of the engagement member 164 may be attached to the disc 162 via an adhesive or the like, and thus the disc 162 and the engagement member 164 may be integrally rotated.

Further, a stepped seating recess 163a may be formed at the disc 162 to allow the head portion 164b and the magnetic member 166 to be seated on and fixed to the stepped seating recess 163a, and thus the disc 162 and the engagement member 164 may be more firmly coupled and integrally rotated.

In the present embodiment, a neodymium magnet may be used as the magnetic member 166, and an electromagnet magnetized by a supply of an induced current may be used in addition to the neodymium magnet.

In the present embodiment, the magnetic member 166 may be symmetrically provided at both sides of the head portion 164b on the basis of the center thereof.

Further, in the present embodiment, a plurality of balls may be used as the rolling member 176 between the first wheel 172 and the second wheel 174 of the bearing unit 170, and the bearing unit 170 may include a plurality of thrust balls bearing configured to support a load generated in an axial direction.

Furthermore, in the present embodiment, the bearing unit 170 has been described as the thrust ball bearing, but in consideration of a working load and the like, a thrust needle roller bearing having a truncated conical roller may be included in the bearing unit 170 as the rolling member 176 between the first wheel 172 and the second wheel 174.

In addition, the bearing unit 170 may employ commercially available various types and kinds of bearings, and the bearing unit 170 may include various types of bearings, such as an angular bearing and the like, having a self-aligning function while supporting an axial load in addition to the thrust ball bearing and the thrust needle roller bearing.

Additionally, in the present embodiment, the interlocked rotational engagement body 160 and the first wheel 172, and the second wheel 174 and the rear surface of the display module 110 may be attached via an adhesive, be physically engaged by the engagement member 164 such as a bolt and the like, be coupled by installing an engaging member such as a hook and the like or a bracket, or be coupled by welding or the like. Coupling structures for the interlocked rotational engagement body 160 and the first wheel 172, and the second wheel 174 and the rear surface of the display module 110 are not limited to the described above, and the coupling structures may be modified in various forms.

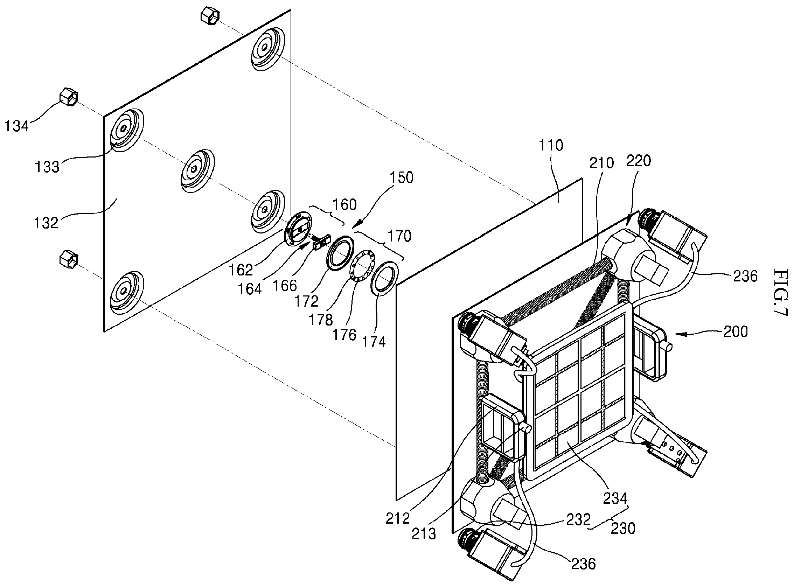

As shown in FIG. 7, the mounting apparatus 150 configured as described above may couple the display module 110 to the profile structure body 130 as the interlocked rotational engagement body 160 is rotated by the display module assembly apparatus 200 disposed on the front side of the display module 110.

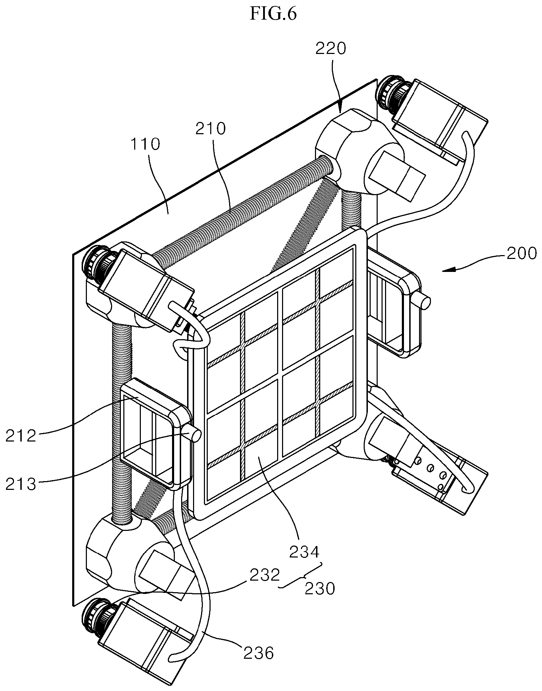

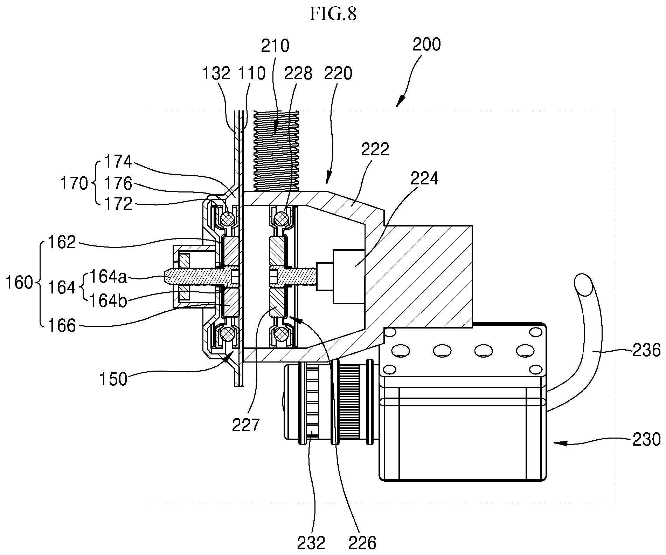

FIG. 6 is a perspective view of a display module assembling apparatus according to one embodiment of the present disclosure, and FIG. 7 is a perspective view illustrating a state in which a display module is assembled using the display module assembling apparatus according to one embodiment of the present disclosure. Further, FIG. 8 is a cross-sectional view illustrating the state in which the display module is assembled using the display module assembling apparatus according to one embodiment of the present disclosure.

Referring to FIGS. 6 to 8, a configuration of the display assembly apparatus 200 of the present embodiment is as follows.

The display module assembly apparatus 200 of the present embodiment may include a frame 210 located on the front side of the display module 110.

Further, at least one rotation module 220 may be provided at one side of the frame 210 and be installed to correspond to the above-described mounting apparatus 150.

The rotation module 220 may generate attractive force to the mounting apparatus 150, rotate the interlocked rotational engagement body 160 of the mounting apparatus 150 using the attractive force, and couple the display module 110 to the profile structure body 130.

For example, in the present embodiment, the mounting apparatus 150 may be fixed to a rear side of the display module 110 at a predetermined position away from a corner of the display module 110.

Further, the rotation module 220 of the display module assembly apparatus 200 may be provided at a position corresponding to the mounting apparatus 150 on the front side of the display module 110.

Since the rotation module 220 is disposed to correspond to the mounting apparatus 150, the display module assembly apparatus 200 may accurately rotate the interlocked rotational engagement body 160.

To this end, the rotation module 220 may include a housing 222 installed at one side of the frame 210. The housing 222 is installed at one side of the frame 210, and preferably, a position of the housing 222 may be adjusted and located at a predetermined position corresponding to the mounting apparatus 150 away from the corner of the display module 110.

Further, a motor 224 may be installed inside the housing 222 via a bracket or the like. Furthermore, a rotational interlocking portion 226 may be provided at a rotational shaft of the motor 224 to rotate the interlocked rotational engagement body 160 of the mounting apparatus 150.

Moreover, the rotational interlocking portion 226 may include a magnetic force generation portion 227 configured to generate a magnetic force to the magnetic member 166 of the interlocked rotational engagement body 160 and rotate the engagement member 164.

The magnetic force generation portion 227 may be provided as a permanent magnet or an electromagnet module and have polarity apposite polarity of the magnetic member 166 of the interlocked rotational engagement body 160. The magnetic force generation portion 227 generates attractive force to the magnetic member 166 of the interlocked rotational engagement body 160, and thus the magnetic force generation portion 227 of the rotational interlocking portion 226 is rotated by the motor 224. Further, as the magnetic force generation portion 227 of the rotational interlocking portion 226 is rotated, the magnetic member 166 of the interlocked rotational engagement body 160 may be rotated by the attractive force in response to the rotation of the magnetic force generation portion 227, the engagement member 164 coupled to the magnetic member 166 may be rotated, and thus the mounting apparatus 150 may be attached to or detached from the engagement plate 132 of the structure 130.

Furthermore, if the magnetic force generation portion 227 is configured as an electromagnet module, a switch 213 may be provided at one side of the frame 210 to control a supply of electricity to the electromagnet module. Preferably, a handle 212 may be provided at one side of the frame 210 to facilitate an operator to grip the assembly apparatus 200, and the switch 213 may be provided at position of a thumb of the operator so as to allow the operator to control a supply of electricity to the magnetic force generation portion 227, i.e., the electromagnet module in a state in which the operator holds the handle 212.

While the magnetic force generation portion 227 has been described as having the polarity opposite the polarity of the magnetic member 166 of the interlocked rotational engagement body 160 in the present embodiment, but the magnetic force generation portion 227 may be disposed to have a polarity the same as the polarity of the magnetic member 166, and at this point, a repulsive force may be generated against a magnetic force generated in the force generation portion 227 such that magnetic member 166 may be rotated.

Further, the rotational interlocking portion 226 may further include an auxiliary bearing unit 228 configured to rotatably support the magnetic force generation portion 227 so as to prevent the magnetic force generation portion 227 from being in contact with the display module 110 while the magnetic force generation portion 227 is rotated.

The auxiliary bearing unit 228 may rotatably support the magnetic force generation portion 227.

Although the auxiliary bearing unit 228 has been described as being installed between the magnetic force generation portion 227 and the housing 222 in the present embodiment, the auxiliary bearing unit 228 may be provided at various positions for guiding the rotation of the magnetic force generation portion 227. For example, the auxiliary bearing unit 228 may be provided to be in close contact with a front surface portion of the display module 110. Here, a contact pad may be provided at the auxiliary bearing unit 228 to be in soft contact with the front surface portion of the display module 110. Accordingly, the contact pad may minimize damage of the display module 110 due to lessen a frictional force between the auxiliary bearing unit 228 and the display module 110.

Alternatively, in the present embodiment, the auxiliary bearing unit 228 may rotatably support a rear side of the magnetic force generation portion 227 without being in close contact with the front side of the display module 110.

The assembly apparatus 200 of the present embodiment may further include an alignment unit 230 configured to align the rotation module 220 to a position corresponding to the mounting apparatus 150 by sensing corners of the display module 110.

For example, the alignment unit 230 may include at least one image capturing unit 232 installed at one side of the rotation module 220 and an image display unit 234 configured to display an image captured by the image capturing unit 232.

The image capturing unit 232 and the image display unit 234 may be connected through an electric wire 236, and be connected using wireless communication.

The operator may recognize a position of corners of the display module 110 by checking the image displayed on the image display unit 234, and, if the image displayed on the image display unit 234 shows if the display module 110 lies at an expected position around the corners, the operator may check an interval between corners of adjacent display modules 110.

When the position of the corner is determined while a position of the display module 110 is aligned, the operator may determine pitches between outermost pixels of the display module 110 and the adjacent display module 110, which are displayed on the image display unit 234, and the operator may align the position of the display module 110 to make the same interval, i.e., the same pitch between the adjacent display modules 110 using the display module assembly apparatus 200.

As described above, when the operator disposes the display module 110 to have a predetermined interval between the adjacent display modules 110 using the image display unit 234, the rotation module 220 may be automatically coupled to a position which is accurately aligned with the mounting apparatus 150 installed at the rear side of the display module 110.

The multi-display device 1 is provided in a form of a narrow bezel type or a zero bezel type in which there is almost no interval between the display modules 10 connected to each other.

Although the alignment unit 230 has been described as being aligned by the operator who checks the image captured in the image capturing unit 232 in the present embodiment, the alignment unit 230 may also automatically control the position of the display module 110.

To this end, the alignment unit 230 may further include a position correction unit (not shown) configured to move the rotation module 220 to a position corresponding to the mounting apparatus 150 on the basis of the corner captured by the image capturing unit 232.

The position correction unit may include a plurality of variable length members provided between the frame 210 and the rotation module 220, and a position of the rotation module 220 may be moved according to a varied length of the plurality of variable length members such that the display module 110 may be automatically aligned with the position corresponding to the mounting apparatus 150.

For example, the variable length member may be a member of which length is adjusted by the motor 224, or is adjusted by a cylinder.

Although the mounting apparatus 150 is described as being coupled to the rear side of the profile structure body 130 via a nut member 134 in the present embodiment, a coupling structure and an engagement structure of the mounting apparatus 150 are not limited to the described above and these may be modified in various forms.

For example, referring to FIG. 8, the nut member 134 provided on a rear side of an engagement plate 132 may be movably provided to have a predetermined clearance while the engagement member 164 of the mounting apparatus 150 is coupled to the nut member 134, and to this end, a nut coupling portion including the nut member 134 may be provided.

The nut coupling portion may include the nut member 134 coupled to the engagement member 164 at the rear side of the engagement plate 132 and to which the mounting apparatus 150 is fixed. Here, the nut member 134 may be configured to be freely movable in a state of being coupled or attached to the engagement plate 132.

Further, the nut coupling portion may include a nut housing 135 configured to position the movably provided nut member 134 on the rear side of the engagement plate 132.

The nut housing 135 may be provided to block surroundings of the through-hole 163 at the rear side of the engagement plate 132. Further, the nut member 134 may be accommodated inside the nut housing 135.

Here, an inner diameter of the nut housing 135 may be formed to be larger than an outer diameter of the nut member 134, and thus the nut member 134 may be accommodated to move in an inner space of the nut housing 135.

Preferably, the inner diameter of the nut housing 135 may be formed to be smaller than a maximum thickness of the nut member 134, and thus the nut member 134 may move freely in a gap between the nut housing 135 and the engagement plate 132 but may not be laid down in a straight upright state.

Further, in the present embodiment, when a thickness of the nut member 134 is increased, the inner diameter of the nut housing 135 may be made to be larger, and thus the nut member 134 may be prevented from being laid down and as well, a gap between the nut member 134 and the nut housing 135 may be formed to be larger.

A method for assembling a display module using the above-described mounting apparatus and the above-described display module assembling apparatus using the same will now be described below.

The display module assembly method may include attaching step, moving step, and coupling step.

First, in the attaching step, the mounting apparatus 150 is installed on the rear side of the display module 110. At this point, the second wheel 174 of the bearing unit 170 of the mounting apparatus 150 may be attached to the rear side of the display module 110 via a member such as an adhesive or the like.

Next, the display module 110 coupled to the mounting apparatus 150 is disposed close to the profile structure body 130 located behind the display module 110.

That is, the operator moves the display module 110 using the display module assembly apparatus 200, and places the display module 110 ahead of the profile structure body 130 to assemble the display module 110.

When the display module assembly apparatus 200 is located on the front side of the display module 110 coupled to the mounting apparatus 150, attraction may be generated at the magnetic member 166 of the mounting apparatus 150 by a magnetic force generated at the magnetic force generation portion 227 of the rotation module 220, and thus the display module 110 may be attached to the rotation module 220 of the display assembly apparatus 200. The magnetic force generation portion 227 of the rotation module 220 may be magnetized to generate the magnetic force by power which is provided when the operator presses the switch 213 attached to the grip 212.

As described above, after the display module 110 is coupled to the display module assembly apparatus 200, the the moving step may be performed.

The display module 110 is moved in a state of being attached to the display module assembly apparatus 200 provided ahead of the display module 110.

When the display module 110 is attached to the display module assembly apparatus 200, the operator may grip the handle 212 of the display module assembly apparatus 200 and easily move the display module 110 to an attachment position of the profile structure body 130.

Next, in the coupling step, the display module assembly apparatus 200 may locate the display module 110 ahead of the profile structure body 130 and couple the display module 110 to the profile structure body 130.

Preferably, the coupling step may further include aligning step of an attachment position of the display module 110 in a state in which the display module 110 is located ahead of the attachment position of the profile structure body 130.

The aligning step aligns the mounting apparatus 150 with the accommodation recess 133 of the engagement plate 132.

At this point, the operator moves the display module 110 to the attachment position of the profile structure body 130 while checking the corner of the display module 110 using the display module assembly apparatus 200.

The mounting apparatus 150 may be installed at a predetermined position the rear side of the display module 110 around the corner, and the mounting apparatus 150 may be aligned with an engagement position of the profile structure body 130, wherein the mounting apparatus 150 will be mounted at the engagement position, while the operator monitors corners of the display module 110.

The operator may align the display module 110 through the alignment unit 230 of the display module assembly apparatus 200. The alignment unit 230 captures the corner of the display module 110 and displays the captured corner on the image display unit 234.

The operator may determine the corner of the display module 110 displayed on the image display unit 234, align the corner of the display module 110 with corners of adjacent display modules 110 so as to allow the corner of the display module 110 to be kept constant with the corners of the adjacent display modules 110, and determine a position at which the display module 110 will be mounted on the profile structure body 130.

Specifically, the operator may align the position of the display module 110 by recognizing an interval between the adjacent display modules 110 at the corner of the display module 110 using the alignment unit 230.

As described above, the operator may determine the corner of the display module 110 displayed on the image display unit 234, check and adjust the mounting position of the display module 110, rotate the mounting apparatus 150 using the rotation module 220 of the assembly apparatus 200, and assemble the display module 110 to the profile structure body 130, thereby completing the assembly.

At this point, the display module assembly apparatus 200 may rotate the rotation module 220.

Accordingly, the rotation member 220 is rotated as the magnetic member 166 is rotated, and thus the mounting apparatus 150 attached to the rear side of the display module 110 is rotated. Specifically, in the mounting apparatus 150, the second wheel 174 of the bearing unit 170 is in a state of being fixed to the rear side of the display module 110, and the first wheel 172 connected via the rolling member 176 is attached to the disc 162 of the interlocked rotational engagement body 160. The disc 162 is rotated with the magnetic member 166 while being supported on the first wheel 172.

As described above, the bearing unit 170 may support a rotation of the interlocked rotational engagement body 160 which is rotated by interlocking with the rotation module 220.

The rotation of the interlocked rotational engagement body 160 is interlocked such that the magnetic member 166 senses attractive force generated in the magnetic force generation portion 227 of the rotation module 220.

A rotational force interlocked with the magnetic member 166 is transmitted to the engagement member 164 and the disc 162 of the interlocked rotational engagement body 160 such that the engagement member 164 is coupled to the engagement plate 132 provided at the profile structure body 130 in a state of being rotatably supported on the first wheel 172.

As described above, in the present embodiment, the display module 110 may be assembled to the profile structure body 130 on the front side of a multi-display device 100 using the display module assembly apparatus 200, and the assembly is performed while an assembled position, a stepped level, and the like are checked with the naked eye.

In accordance with the present disclosure, a plurality of display modules can be easily attached or detached in a multi-display device at a front surface of the multi-display device. In particular, if a partial repair or replacement is required, a corresponding display module can be selected and removed without an overall disassembly.

Further, in accordance with the present disclosure, since a work can be performed while a stepped level of the display module is determined at the front side of the display module when the display module is installed, the work can be easily performed and as well, an arrangement state can be adjusted more accurately such that an alignment work can be more accurately easily performed.

Furthermore, in accordance with the present disclosure, since any engagement means or space is not required at the front side of the display module, an interval between the display modules can be further reduced. Accordingly a display quality can be improved because distortion of display at a border area can be reduced, where the adjacent display modules meet.

Moreover, in accordance with the present disclosure, since the display module can be removed from a multi-display device at the front side of the display module, any additional work at the rear side of the display module is unnecessary. Accordingly any additional configuration for separating or rotating a profile structure body for a work at the rear side of the display module is not required, and thus an entire volume of the display module can be further reduced such that there is advantageous for space utilization, various arrangement is possible according to an installation space, and infinite expansion is possible.

Although the present disclosure has been described with reference to exemplary embodiments thereof, the present disclosure is not limited thereby. Indeed, the exemplary embodiments are provided for illustrative and non-limitative purposes.

### List of reference signs

- 1: multi-display device
- 10: display module
- 100: multi-display device
- 110: display module
- 130: profile structure body
- 132: engagement plate
- 133: accommodation recess
- 134: nut member
- 135: nut housing
- 150: mounting apparatus
- 160: interlocked rotational engagement body
- 162: disc
- 163: through-hole
- 163a: stepped seating recess
- 164: engagement member
- 164a: body
- 164b: head portion
- 166: magnetic member
- 169: protrusion part
- 170: bearing unit
- 172: first wheel
- 174: second wheel
- 176: rolling member
- 178: retainer
- 200: display module assembly apparatus
- 210: frame
- 212: handle
- 213: switch
- 220: rotation module
- 222: housing
- 224: motor
- 226: rotational interlocking portion
- 227: magnetic force generation portion
- 228: auxiliary bearing unit
- 230: alignment unit
- 232: image capturing unit
- 234: image display unit
- 236: electric wire
- 30: profile structure body

## Claims

1. Mounting apparatus (150) for coupling a display module (110) to a profile structure body (130), the mounting apparatus (150) comprising
an interlocked rotational engagement body (160) configured to be coupled to the profile structure body (130) provided at a rear side of the display module (110) and configured to be rotated with an assembling apparatus located on a front surface of the display module (110), the interlocked rotational engagement body (160) including
an engagement member (164), and
a magnetic member (166) fixed to the engagement member (164),
wherein the mounting apparatus (150) is adapted to be fixed to an engagement plate (132) of the profile structure body (130) by a rotational movement of the engagement member (164) induced by a magnetic force acting on the magnetic member (166);
**characterized in that** the mounting apparatus (150) further comprises a bearing unit (170) for coupling the mounting apparatus (150) to the rear side of the display module (110) and to which the interlocked rotational engagement body (160) is rotatably coupled such that the bearing unit (170) is provided between the interlocked rotational engagement body (160) and a rear surface of the display module (110).

2. Mounting apparatus (150) according to claim 1,
wherein the interlocked rotational engagement body (160) further comprises a disc (162) including
a through-hole (163) and
a stepped seating recess (163a);
wherein the engagement member (164) comprises
a body (164a) passing through the through-hole (163) and
a head portion (164b); and
wherein the head portion (164) and the magnetic member (166) are seated in the stepped seating recess (163a).

3. Mounting apparatus (150) according to claim 1 or 2,
wherein the bearing unit (170) includes
a first wheel (172), and
a second wheel (174);
wherein the first wheel (172) is attached to the interlocked rotational engagement body (160).

4. Display module (110) comprising
a display panel, and
at least one mounting apparatus (150) according to any one of the preceding claims, wherein the mounting apparatus (150) is fixed to a backside of the display panel.

5. Profile structure body (130), comprising
at least one engagement plate (132); and
a display module (110) received in the at least one engagement plate (132), wherein the display module (110) is according to claim 4.

6. Profile structure body (130) according to claim 5,
wherein the engagement plate (132) comprises an accommodation recess (133) for accommodating the mounting apparatus (150).

7. Profile structure body (130) according to any one of claims 5 or 6, wherein the display module (110) is according to claim 2, the profile structure body (130) comprising a nut member (134), wherein the nut member (134) is adapted to receive the body (164a) of the engagement member (164), and
a nut housing (135), wherein the nut member (134) is accommodated in the nut housing (135).

8. System comprising:
a mounting apparatus (150) according to any one of claims 1 to 3, and
a rotation module (220) comprising a rotatable magnetic force generation portion (227) for rotating the interlocked rotational engagement body (160) of the mounting apparatus (150) by magnetic forces acting on the magnetic member of the mounting apparatus (150).

9. System according to claim 8,
wherein the magnetic force generation portion (227) comprises an electromagnet module.

10. System according to any one of the claims 8 or 9,
wherein the rotation module (220) comprises a motor (224) and/or an auxiliary bearing unit (228).

11. System comprising:
a mounting apparatus (150) according to any one of claims 1 to 3, and
a display module assembly apparatus (200) comprising:
at least one rotation module (220) comprising a rotatable magnetic force generation portion (227) for rotating the interlocked rotational engagement body (160) of the mounting apparatus (150) by magnetic forces acting on the magnetic member of the mounting apparatus (150),
wherein the display module assembly apparatus (200) is adapted for fastening a display module (110) according to claim 4 to a profile structure body according to any one of claims 5 to 7.

12. System according to claim 11, wherein the magnetic force generation portion (227) comprises an electromagnet module; and/or
wherein the rotation module (220) comprises a motor (224) and/or an auxiliary bearing unit (228).

13. System according to claim 11 or 12, the display module assembly apparatus (200) further comprising
an alignment unit (230) including
an image capturing unit (232) for capturing an image of a corner of the display module (110).

14. System according to claim 13,
wherein the alignment unit (230) further comprises a position correction unit.

15. Multi-display device (100) comprising
at least one display module (110) according to claim 4, and
a profile structure body (130) according to any one of claims 5 to 7.

## Patentansprüche

1. Befestigungsvorrichtung (150) zum Koppeln eines Anzeigemoduls (110) an einen Profilstrukturkörper (130), wobei die Befestigungsvorrichtung (150) Folgendes umfasst:
einen verzahnten Dreheingriffkörper (160), der konfiguriert ist, an den Profilstrukturkörper (130), der auf einer Rückseite des Anzeigemoduls (110) vorgesehen ist, gekoppelt zu sein, und konfiguriert ist, mit einer Anordnungsvorrichtung, die an einer Frontoberfläche des Anzeigemoduls (110) angeordnet ist, gedreht zu werden, wobei der verzahnte Dreheingriffkörper (160) Folgendes enthält:
ein Eingriffelement (164) und
ein Magnetelement (166), das am Eingriffelement (164) befestigt ist,
wobei die Befestigungsvorrichtung (150) ausgelegt ist, durch eine Drehbewegung des Eingriffelements (164), die durch eine Magnetkraft induziert wird, die auf das Magnetelement (166) wirkt, an einer Eingriffplatte (132) des Profilstrukturkörpers (130) befestigt zu werden;
**dadurch gekennzeichnet, dass**
die Befestigungsvorrichtung (150) ferner eine Lagereinheit (170) zum Koppeln der Befestigungsvorrichtung (150) an die Rückseite des Anzeigemoduls (110) umfasst, an die der verzahnte Dreheingriffkörper (160) drehbar gekoppelt ist, derart, dass die Lagereinheit (170) zwischen dem verzahnten Dreheingriffkörper (160) und einer Rückoberfläche des Anzeigemoduls (110) vorgesehen ist.

2. Befestigungsvorrichtung (150) nach Anspruch 1,
wobei der verzahnte Dreheingriffkörper (160) ferner eine Scheibe (162) umfasst, die Folgendes enthält:
ein Durchgangsloch (163) und
eine abgestufte Aufnahmeaussparung (163a);
wobei das Eingriffelement (164) Folgendes umfasst:
einen Körper (164a), der durch das Durchgangsloch (163) verläuft, und
einen Kopfabschnitt (164b);
wobei der Kopfabschnitt (164) und das Magnetelement (166) in die abgestufte Aufnahmeaussparung (163a) gesetzt sind.

3. Befestigungsvorrichtung (150) nach Anspruch 1 oder 2,
wobei die Lagereinheit (170) Folgendes enthält:
ein erstes Rad (172); und
ein zweites Rad (174),
wobei das erste Rad (172) am verzahnten Dreheingriffkörper (160) angebracht ist.

4. Anzeigemodul (110), das Folgendes umfasst:
eine Anzeigetafel; und
mindestens eine Befestigungsvorrichtung (150) nach einem der vorhergehenden Ansprüche,
wobei die Befestigungsvorrichtung (150) an einer Rückseite der Anzeigetafel befestigt ist.

5. Profilstrukturkörper (130), der Folgendes umfasst:
mindestens eine Eingriffplatte (132); und
ein Anzeigemodul (110), das in die mindestens eine Eingriffplatte (132) aufgenommen ist, wobei das Anzeigemodul (110) ein Anzeigemodul nach Anspruch 4 ist.

6. Profilstrukturkörper (130) nach Anspruch 5,
wobei die Eingriffplatte (132) eine Aufnahmeaussparung (133) zum Aufnehmen der Befestigungsvorrichtung (150) umfasst.

7. Profilstrukturkörper (130) nach einem der Ansprüche 5 oder 6, wobei das Anzeigemodul (110) ein Anzeigemodul nach Anspruch 2 ist und der Profilstrukturkörper (130) Folgendes umfasst:
ein Mutterelement (134), wobei das Mutterelement (134) ausgelegt ist, den Körper (164a) des Eingriffelements (164) aufzunehmen; und
ein Muttergehäuse (135), wobei das Mutterelement (134) in das Muttergehäuse (135) aufgenommen ist.

8. System, das Folgendes umfasst:
eine Befestigungsvorrichtung (150) nach einem der Ansprüche 1 bis 3; und
ein Drehmodul (220), das einen drehbaren Magnetkrafterzeugungsabschnitt (227) zum Drehen des verzahnten Dreheingriffkörpers (160) der Befestigungsvorrichtung (150) durch Magnetkräfte, die auf das Magnetelement der Befestigungsvorrichtung (150) wirken, umfasst.

9. System nach Anspruch 8,
wobei der Magnetkrafterzeugungsabschnitt (227) ein Elektromagnetmodul umfasst.

10. System nach einem der Ansprüche 8 oder 9,
wobei das Drehmodul (220) einen Motor (224) und/oder eine Hilfslagereinheit (228) umfasst.

11. System, das Folgendes umfasst:
eine Befestigungsvorrichtung (150) nach einem der Ansprüche 1 bis 3; und
eine Anzeigemodulanordnungsvorrichtung (200), die Folgendes umfasst:
mindestens ein Drehmodul (220), das einen drehbaren Magnetkrafterzeugungsabschnitt (227) zum Drehen des verzahnten Dreheingriffkörpers (160) der Befestigungsvorrichtung (150) durch Magnetkräfte, die auf das Magnetelement der Befestigungsvorrichtung (150) wirken, umfasst,
wobei die Anzeigemodulanordnungsvorrichtung (200) zum Befestigen eines Anzeigemoduls (110) nach Anspruch 4 an einem Profilstrukturkörper nach einem der Ansprüche 5 bis 7 ausgelegt ist.

12. System nach Anspruch 11, wobei der Magnetkrafterzeugungsabschnitt (227) ein Elektromagnetmodul umfasst und/oder
das Drehmodul (220) einen Motor (224) und/oder eine Hilfslagereinheit (228) umfasst.

13. System nach Anspruch 11 oder 12, wobei die Anzeigemodulanordnungsvorrichtung (200) ferner Folgendes umfasst:
eine Ausrichtungseinheit (230), die Folgendes enthält:
eine Bildaufnahmeeinheit (232) zum Aufnehmen eines Bilds einer Ecke des Anzeigemoduls (110).

14. System nach Anspruch 13,
wobei die Ausrichtungseinheit (230) ferner eine Positionskorrektureinheit umfasst.

15. Mehrfachanzeigeeinrichtung (100), die Folgendes umfasst:
mindestens ein Anzeigemodul (110) nach Anspruch 4 und
einen Profilstrukturkörper (130) nach einem der Ansprüche 5 bis 7.

## Revendications

1. Appareil de montage (150) pour coupler un module d'affichage (110) à un corps de structure profilée (130), l'appareil de montage (150) comportant :
un corps de prise rotative interverrouillé (160) configuré pour être couplé au corps de structure profilée (130) agencé sur un côté arrière du module d'affichage (110) et configuré pour tourner avec un appareil d'assemblage situé sur une surface avant du module d'affichage (110), le corps de prise rotative interverrouillé (160) incluant :
un élément de prise rotative (164), et
un élément magnétique (166) fixé à l'élément de prise (164), dans lequel l'appareil de montage (150) est adapté pour être fixé à une plaque de prise (132) du corps de structure profilée (130) par un mouvement de rotation de l'élément de prise (164) induit par une force magnétique agissant sur l'élément magnétique (166) ;
**caractérisé en ce que** l'appareil de montage (150) comporte en outre un bloc-palier (170) pour coupler l'appareil de montage (150) au côté arrière du module d'affichage (110) et auquel le corps de prise rotative interverrouillé (160) est couplé en rotation de telle sorte que le bloc-palier (170) est agencé entre le corps de prise rotative interverrouillé (160) et une surface arrière du module d'affichage (110).

2. Appareil de montage (150) selon la revendication 1,
dans lequel le corps de prise rotative interverrouillé (160) comporte en outre un disque (162) incluant :
un trou traversant (163) et
un évidement d'appui étagé (163a) ;
dans lequel l'élément de prise (164) comporte :
un corps (164a) passant à travers le trou traversant (163) et
une partie de tête (164b) ; et
dans lequel la partie de tête (164) et l'élément magnétique (166) sont en appui dans l'évidement d'appui étagé (163a).

3. Appareil de montage (150) selon la revendication 1 ou 2,
dans lequel le bloc-palier (170) inclut :
une première roue (172) et
une seconde roue (174) ;
dans lequel la première roue (172) est fixée au corps de prise rotative interverrouillé (160).

4. Module d'affichage (110) comportant :
un panneau d'affichage, et
au moins un appareil de montage (150) selon l'une quelconque des revendications précédentes,
dans lequel l'appareil de montage (150) est fixé à un côté arrière du panneau d'affichage.

5. Corps de structure profilée (130), comportant :
au moins une plaque de prise (132) ; et
un module d'affichage (110) reçu dans la au moins une plaque de prise (132), dans lequel le module d'affichage (110) est selon la revendication 4.

6. Corps de structure profilée (130) selon la revendication 5,
dans lequel la plaque de prise (132) comporte un évidement de réception (133) pour recevoir l'appareil de montage (150).

7. Corps de structure profilée (130) selon l'une quelconque des revendications 5 ou 6,
dans lequel le module d'affichage (110) est selon la revendication 2, le corps de structure profilée (130) comportant :
un élément d'écrou (134), dans lequel l'élément d'écrou (134) est adapté pour recevoir le corps (164a) de l'élément de prise (164), et
un logement d'écrou (135), dans lequel l'élément d'écrou (134) est reçu dans le logement d'écrou (135).

8. Système comportant :
un appareil de montage (150) selon l'une quelconque des revendications 1 à 3, et
un module de rotation (220) comportant une partie de génération de force magnétique rotative (227) pour faire tourner le corps de prise rotative interverrouillé (160) de l'appareil de montage (150) par des forces magnétiques agissant sur l'élément magnétique de l'appareil de montage (150).

9. Système selon la revendication 8,
dans lequel la partie de génération de force magnétique (227) comporte un module à électro-aimant.

10. Système selon l'une quelconque des revendications 8 ou 9,
dans lequel le module de rotation (220) comporte un moteur (224) et/ou un bloc-palier auxiliaire (228).

11. Système comportant :
un appareil de montage (150) selon l'une quelconque des revendications 1 à 3, et
un appareil d'assemblage de module d'affichage (200) comportant :
au moins un module de rotation (220) comportant une partie de génération de force magnétique rotative (227) pour faire tourner le corps de prise rotative interverrouillé (160) de l'appareil de montage (150) par des forces magnétiques agissant sur l'élément magnétique de l'appareil de montage (150),
dans lequel l'appareil d'assemblage de module d'affichage (200) est adapté pour fixer un module d'affichage (110) selon la revendication 4 à un corps de structure profilée selon l'une quelconque des revendications 5 à 7.

12. Système selon la revendication 11, dans lequel la partie de génération de force magnétique (227) comporte un module à électro-aimant ; et/ou
dans lequel le module de rotation (220) comporte un moteur (224) et/ou un bloc-palier auxiliaire (228).

13. Système selon la revendication 11 ou 12, l'appareil d'assemblage de module d'affichage (200) comportant en outre :
une unité d'alignement (230) incluant :
une unité de capture d'image (232) pour capturer une image d'un coin du module d'affichage (110).

14. Système selon la revendication 13,
dans lequel l'unité d'alignement (230) comporte en outre une unité de correction de position.

15. Dispositif d'affichage multiple (100) comportant :
au moins un module d'affichage (110) selon la revendication 4, et
un corps de structure profilée (130) selon l'une quelconque des revendications 5 à 7.
